# EUROPÄISCHE PATENTSCHRIFT

(11) **EP 1 203 518 B1**
(45) Veröffentlichungstag und Bekanntmachung des Hinweises auf die Patenterteilung: **22.01.2003**
(21) Anmeldenummer: 00962194.7
(22) Anmeldetag: 03.08.2000
(51) Int. Cl.: H05K 13/08, G01R 31/312

(54) **VERFAHREN ZUM ERKENNEN DER LAGE ODER DER OBERFLÄCHENSTRUKTUR EINES GEGENSTANDS UND ANWENDUNG DES VERFAHRENS SOWIE EINE MASCHINE ZUR VERARBEITUNG VON GEGENSTÄNDEN**
METHOD FOR DETECTING THE POSITION OR THE SURFACE STRUCTURE OF AN OBJECT AND APPLICATION OF SAID METHOD AS WELL AS A MACHINE FOR TREATING OBJECTS
PROCEDE POUR IDENTIFIER LA POSITION OU LA STRUCTURE SUPERFICIELLE D'UN OBJET ET UTILISATION DUDIT PROCEDE, AINSI QUE MACHINE APPROPRIEE POUR TRAVAILLER DES OBJETS

(30) Priorität: 12.08.1999 DE 19938062
(43) Veröffentlichungstag der Anmeldung: 08.05.2002
(73) Patentinhaber: SIEMENS AKTIENGESELLSCHAFT, 80333 München (DE)
(72) Erfinder: SCHÜTZ, Dietmar, D-81541 München (DE)
(86) Internationale Anmeldenummer: DE0002603
(87) Internationale Veröffentlichungsnummer: WO01013698

(56) Entgegenhaltungen:
- EP-A- 0 305 148
- EP-A- 0 759 559

## Beschreibung

Die Erfindung betrifft ein Verfahren zum Erkennen der Lage oder der Oberflächenstruktur eines Gegenstands, wobei ein Bild des Gegenstands erzeugt wird. Ferner betrifft die Erfindung die Verwendung des Verfahrens.

Werkzeugmaschinen, insbesondere Bestückautomaten, stellen hohe Anforderungen an die Genauigkeit bei der Erkennung, Handhabung und Verarbeitung von Werkstücken oder Bauteilen. Ein wesentliches Problem dabei sind Ungenauigkeiten bei der Bereitstellung der Werkstücke/Bauteile, die z. B. durch einen notwendigen Spielraum zwischen Bauteil und Bauteilträger entstehen. Diese Ungenauigkeiten sind im allgemeinen größer als die geforderte maximale Endungenauigkeit und müssen daher im Laufe der Bearbeitung korrigiert werden. Insbesondere ist es wünschenswert, neben der Feststellung der Position des Werkstückes oder Bauteiles, zu erkennen, ob es äußerlich beschädigt ist und dadurch von vornherein von der Weiterverarbeitung ausgeschlossen werden muß.

Es sind Verfahren zur Erkennung von Werkstücken/Bauteilen bekannt, die diese optisch abtasten und ein entsprechendes zweidimensionales Bild mit darin enthaltener Information aus der dritten Dimension (Tiefeninformation) erstellen. Die dafür benötigten optischen Sensoren sind aufwendig und teuer in der Herstellung. Aufgrund ihres aufwendigen Aufbaus sind sie schlecht integrierbar und können daher nur an bestimmten Stellen des Verarbeitungsprozesses von der Bereitstellung des Bauteils bis zur endgültigen Plazierung angeordnet werden. Daher sind diese bekannten Verfahren gekennzeichnet durch eine nachträgliche Korrektur, beispielsweise der Lage des Bauteils, bzw. der Verwerfung des Bauteiles als Ausschuß. Diese Vorgehensweise führt insbesondere bei Bestückautomaten zu nicht unerheblichen Zeitverlusten. Ferner liefert die optische Abtastung der Werkstücke ein zweidimensionales Bild mit einer Fülle von Informationen auch aus der dritten Dimension, die in den meisten Fällen gar nicht benötigt wird. Im wesentlichen kommt es darauf an, die Position eines Werkstücks zu erkennen. Bei Bestückautomaten ist es darüber hinaus notwendig, diejenigen Teile des Bauteils zu überprüfen, die später in der Leiterplattenebene zu Liegen kommen. Ein Beispiel dafür wäre die Erkennung eines verbogenen Anschlußpins eines elektrischen Bauelementes.

Es sind darüber hinaus kapazitive Fingerabdruck-Sensoren bekannt, die durch Abtasten der Oberfläche eines Fingers ein Bild des Fingerabdrucks erzeugen, der zur Personenidentifikation verwendet werden kann. Diese Sensoren sind mit Hilfe der Siliziumtechnologie leicht und billig herzustellen und darüber hinaus integrierbar. Solche Sensoren sind z. B. bekannt aus US 4,353,056.

EP-A-0 759 559 offenbart ein Verfahren und ein Testsystem mit einem kapazitiven Meßfühler zum Erkennen der Orientierung von Bauelementen, die auf einer Leiterplatte angebracht werden wobei die kapazitive Kopplung des Meßfühlers mit Anschlüssen der Bauelemente ausgewertet wird.

Ziel der vorliegenden Erfindung ist es, ein Verfahren zum Erkennen der Lage oder der Oberflächenstruktur eines Gegenstands bereitzustellen, bei dem unter Verwendung eines leicht und billig herstellbaren Sensors ein Bild des Gegenstandes erzeugt wird, das größtenteils nur die relevante Information enthält.

Dieses Ziel wird erfindungsgemäß durch ein Verfahren nach Anspruch 1 erreicht. Vorteilhafte Ausgestaltungen der Erfindung und Anwendungen der Erfindung sowie eine Maschine, die die Erfindung verwendet, sind den weiteren Ansprüchen zu entnehmen.

Die Erfindung gibt ein Verfahren zum Erkennen der Lage oder der Oberflächenstruktur eines Gegenstands an, wobei der Gegenstand auf oder dicht über einem Array von kapazitiven Einzelsensoren plaziert wird. Die laterale Ausdehnung der Einzelsensoren darf dabei höchstens die Hälfte der lateralen Ausdehnung des zu erkennenden Gegenstandes betragen. Wenigstens einer der kapazitiven Einzelsensoren erfährt durch die Anwesenheit des Gegenstands eine kapazitive Störung an seiner Oberfläche. Diese Störung eines oder mehrerer Einzelsensoren wird elektronisch ausgewertet und zu einem Bild des Gegenstandes verarbeitet.

Durch die erfindungsgemäße Plazierung eines Gegenstandes auf oder dicht über einem Array kapazitiver Einzelsensoren erreicht man, daß das vom Array gelieferte Bild des Gegenstandes nur eine geringe Tiefeninformation über die nahe am Sensor befindlichen Teile des Gegenstandes enthält. Denn mit zunehmender Entfernung vom kapazitiven Sensor wird die kapazitive Störung so gering, daß sie nur schwach oder gar nicht mehr erkannt werden kann. Ferner entfallen Störungen der Bildverarbeitung durch Beleuchtungsprobleme oder inhomogene Hintergründe. Die Komponenten nahe am Sensor treten im Bild deutlich hervor, während weiter entfernte Elemente, die damit auch außerhalb z. B. der Leiterplattenebene liegen, schwächer oder gar nicht in Erscheinung treten. Zudem ist ein kapazitiver Sensor im einfachsten Fall eine Anordnung von Einzelkondensatoren, die sich leicht und kostengünstig realisieren läßt.

Besonders vorteilhafterweise verwendet man als Array kapazitiver Einzelsensoren einen kapazitiven Fingerabdruck-Sensor auf Halbleiterbasis. In diesem Fall sind die kapazitiven Einzelsensoren Feldeffekttransistoren. Ein solcher Sensor ist mit den Mitteln der Siliziumtechnologie kostengünstig und integriert herstellbar.

Das erfindungsgemäße Verfahren ist besonders für Anwendungen geeignet, bei denen als Gegenstand ein mechanisches Werkstück oder ein elektrisches Bauelement in seiner Oberflächenstruktur oder Position erkannt wird. Insbesondere bei elektrischen Bauelementen eignet sich das erfindungsgemäße Verfahren zur Erkennung der Lage und der Orientierung von Anschlußpins, da hier nur die Information über die für das Bauelement vorgesehene Leiterplattenebene benötigt wird.

Das erfindungsgemäße Verfahren ist besonders gut geeignet zur Anwendung in Bestückautomaten, die eine Werkzeugmaschine und einen Bauelementebereitsteller aufweisen. Die leicht integrierbaren Fingerabdruck-Sensoren können ohne weiteres am Bauelementebereitsteller oder in der Werkzeugmaschine montierte werden. Dadurch wird es ermöglicht, die Lage und die Orientierung von Anschlußpins elektrischer Bauelemente bereits zu Beginn des Verarbeitungsprozesses zu überprüfen, so daß auf nachträgliche Korrekturen verzichtet werden kann. Zudem können dadurch defekte Bauelemente, beispielsweise mit abgebrochenen oder verbogenen Anschlußpins, sofort aussortiert werden, ohne daß unnötig Prozeßzeit für ein defektes Bauelement verlorengeht.

Gegebenenfalls können auch weitere gleich- oder andersartige Sensoren, beispielsweise zur Erkennung der Oberflächenstruktur von Vorder- und Rückseite oder zum gleichzeitigen Erkennen von Lage und Oberflächenstruktur, in die Bestückautomaten integriert werden.

Ferner gibt die Erfindung eine Maschine zum Verarbeiten von Gegenständen an, die ein Werkzeug zum Bereitstellen der Gegenstände und ein Werkzeug zum Transport der Gegenstände aufweist. In eines oder beide Werkzeuge ist ein Array kapazitiver Einzelsensoren integriert, das die Lage und/oder die Oberflächenstruktur der Gegenstände gemäß dem oben beschriebenen Verfahren erkennt.

Im folgenden wird die Erfindung anhand eines Ausführungsbeispiels und den dazugehörigen Figuren näher erläutert.
- Figur 1: zeigt einen Gegenstand, der erfindungsgemäß über einem Fingerabdruck-Sensor plaziert ist, in Draufsicht.
- Figur 2: zeigt den über einem Fingerabdruck-Sensor plazierten Gegenstand aus Figur 1 im Querschnitt.

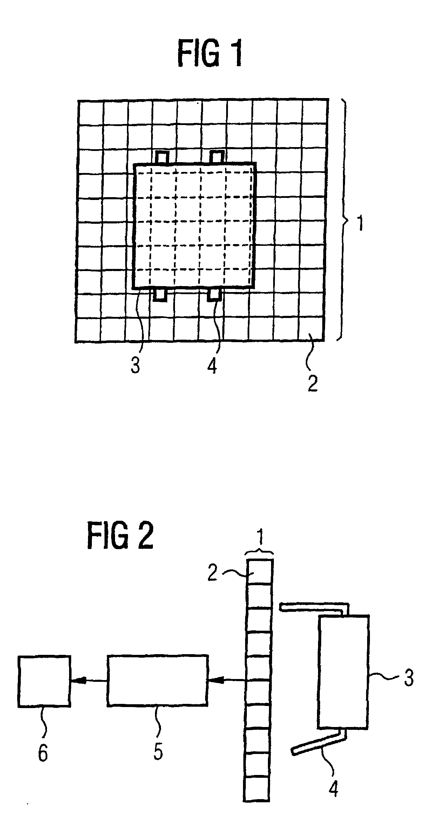

Figur 1 zeigt ein elektrisches Bauelement 3 mit Anschlußpins 4, welches über einem Sensorarray 1 positioniert ist. Das Sensorarray 1 besteht aus mehreren kapazitiven Einzelsensoren 2. Die laterale Ausdehnung der kapazitiven Einzelsensoren 2 ist wesentlich kleiner als die laterale Ausdehnung des elektrischen Bauelements 3. Dadurch wird gewährleistet, daß ein Bild des elektrischen Bauelements 3 von hinreichender Auflösung entsteht.

Figur 2 zeigt ein elektrisches Bauelement 3 mit Anschlußpins 4, das dicht neben einem Sensorarray 1 angeordnet ist. Das Sensorarray 1 besteht aus kapazitiven Einzelsensoren 2. An das Sensorarray ist eine Auswerteelektronik 5 mit nachfolgender Bildverarbeitung 6 angeschlossen. Mit dem erfindungsgemäßen Verfahren, angewandt auf die Erkennung der Orientierung von Anschlußpins elektrischer Bauelemente, kann beispielsweise der unten in Figur 2 dargestellte abgeknickte Anschlußpin 4 erkannt und das elektrische Bauelement 3 als Ausschuß aus dem weiteren Verarbeitungsprozeß ausgeschlossen werden.

Die Erfindung beschränkt sich nicht auf die beispielhaft gezeigten speziellen Ausführungsformen, sondern wird in ihrer allgemeinsten Form durch Anspruch 1 definiert.

## Patentansprüche

1. Verfahren zum Erkennen der Lage und/oder der Oberflächenstruktur eines Werkstückes oder Bauteiles in einem Verarbeitungsprozeß (3),
- wobei der Gegenstand (3) auf oder dicht über einem Array (1) kapazitiver Einzelsensoren (2), deren jeweilise laterale Ausdehnungen höchstens die Hälfte der lateralen Ausdehnung des zu erkennenden Gegenstandes (3) beträgt, plaziert wird,
- wodurch eine kapazitive Störung der Oberfläche wenigstens eines Einzelsensors (2) verursacht wird, welche elektronisch ausgewertet und zu einem Bild des Gegenstandes (3) verarbeitet wird.

2. Verfahren nach Anspruch 1,
wobei das Array (1) ein kapazitiver Fingerabdruck-Sensor auf Halbleiterbasis ist.

3. Anwendung des Verfahrens nach Anspruch 1 oder 2,
wobei Lage oder Oberflächenstruktur eines mechanischen Werkstücks oder eines elektrischen Bauelements erkannt wird.

4. Anwendung des Verfahrens nach Anspruch 3 zur Erkennung der Lage und der Orientierung von Anschlußpins (4) eines elektrischen Bauelementes (3).

5. Anwendung des Verfahrens nach Anspruch 3 zur Erkennung der Lage und der Orientierung von Anschlußpins (4) eines elektrischen Bauelementes (3) in einem Bestückautomaten, der eine Werkzeugmaschine und einen Bauelementebereitsteller aufweist, wobei der Fingerabdruck-Sensor in den Bauelementebereitsteller oder in die Werkzeugmaschine integriert wird.

6. Maschine zum Verarbeiten von Gegenständen (3) mit einem Werkzeug zum Bereitstellen der Gegenstände und einem Werkzeug zum Transport der Gegenstände, bei der ein Fingerabdruck-Sensor in eines oder beide Werkzeuge integriert ist, der die Lage und/oder die Oberflächenstruktur der Gegenstände erkennt und ein Array (1) kapazitiver Einzelsensoren (2) aufweist und daß mittel vorgesehen sind, die die kapazitiven Störungen der Oberfläche des Sensor-Arrays auswerten und zu einem Bild des Gegenstandes (3) verarbeiten.

## Claims

1. Method for detecting the position and/or the surface structure of a workpiece or component in a processing cycle (3)
- in which the object (3) is placed on or right over an array (1) of capacitive individual sensors (2) whose respective lateral extents are at most half the lateral extent of the object (3) to be detected,
- the capacitive disturbance of the surface of at least one individual sensor (2) thereby being caused, which is evaluated electronically and processed to form an image of the object (3).

2. Method according to Claim 1, in which the array (1) is a capacitive fingerprint sensor based on a semiconductor.

3. Application of the method according to Claim 1 or 2, in which the position or surface structure of a mechanical workpiece or an electric component is detected.

4. Application of the method according to Claim 3 for detecting the position and the orientation of terminal pins (4) of an electric component (3).

5. Application of the method according to Claim 3 for detecting the position and the orientation of terminal pins (4) of an electric component (3) in an automatic component mounting machine that has a machine tool and a component provider, the fingerprint sensor being integrated in the component provider or in the machine tool.

6. Machine for processing objects (3) with the aid of a tool for providing the objects and a tool for transporting the objects, in which there is integrated in one or both tools a fingerprint sensor which detects the position and/or the surface structure of the objects and has an array (1) of capacitive individual sensors (2), and in which means are provided which evaluate the capacitive disturbances at the surface of the sensor-array and process them to form an image of the object (3).

## Revendications

1. Procédé pour identifier la position et/ou la structure superficielle d'une pièce à usiner ou d'un composant (3) dans le cadre d'un processus de traitement,
- dans lequel l'objet (3) est placé sur ou juste au-dessus d'un réseau (« array ») (1) de capteurs capacitifs distincts (2) dont la dilatation latérale est, pour chacun d'eux, au maximum égale à la moitié de la dilatation latérale de l'objet à identifier (3),
- ceci créant une perturbation capacitive à la surface d'au moins l'un des capteurs distincts (2), laquelle fait l'objet d'une analyse électronique et est traitée pour donner une image dudit objet (3).

2. Procédé selon la revendication 1, dans lequel le réseau (1) est un capteur capacitif d'empreinte digitale à base de semi-conducteurs.

3. Utilisation du procédé selon la revendication 1 ou 2, dans laquelle est identifiée la position ou la structure superficielle d'une pièce mécanique à usiner ou d'un composant électrique.

4. Utilisation du procédé selon la revendication 3 pour identifier la position et l'orientation de broches de connexion (4) d'un composant électrique (3).

5. Utilisation du procédé selon la revendication 3 pour identifier la position et l'orientation de broches de connexion (4) d'un composant électrique (3) dans un automate de placement comprenant une machine-outil et un dispositif de mise à disposition de composants, le capteur d'empreinte digitale étant intégré dans ledit dispositif de mise à disposition de composants ou dans la machine-outil.

6. Machine pour travailler des objets (3), comprenant un outil pour la mise à disposition desdits objets et un outil pour le transport desdits objets, dans laquelle un capteur d'empreinte digitale identifiant la position et/ou la structure superficielle des objets est intégré dans l'un des outils, ou dans les deux, ladite machine présentant un réseau (1) de capteurs capacitifs distincts (2) et des moyens d'analyse des perturbations capacitives à la surface du réseau de capteurs ainsi que leur traitement pour fournir une image de l'objet (3) étant prévus.
